# DEMANDE DE BREVET EUROPEEN

(11) **EP 0 883 181 A1**
(43) Date de publication de la demande: **09.12.1998**
(21) Numéro de dépôt: 98401260.9
(22) Date de dépôt: 27.05.1998
(51) Int. Cl.: H01L 23/495

(54) **Dispositif semi-conducteur et procédé de connexion des fils internes de masse d'un tel dispositif**

(30) Priorité: 02.06.1997 FR 9706748
(71) Demandeur: SGS-THOMSON MICROELECTRONICS S.A., 94250 Gentilly (FR)
(72) Inventeur: Champagne, Michel, 38320 Eybens (FR)
(74) Mandataire: Casalonga, Axel

(57) **Abrégé**

Le dispositif semiconducteur comprend, à l'intérieur d'un boîtier (21), une grille de connexion (2) comportant une plaque centrale (3) pour recevoir une pastille (1) formant un circuit intégré et une pluralité de pattes de connexion (5) disposées autour de la plaque centrale (3) et débordant à l'extérieur du boîtier (21), et des fils internes de connexion (9, 10, 11) ayant pour certains d'entre eux (9, 11) une extrémité (12, 13) soudée sur la plaque centrale. La plaque centrale (3) comporte plusieurs passages traversants (7) ménagés dans une zone périphérique (6) de la plaque centrale, chacun de ces passages traversants (7) se situant sensiblement dans le prolongement d'une patte de connexion (5). Les extrémités (12, 13) des fils de masse soudées sur la plaque centrale se situent au voisinage de certains au moins de ces passages traversants.

## Description

L'invention concerne les dispositifs semiconducteurs encapsulés dans une résine d'enrobage ou boîtier, et plus particulièrement leur grille ainsi que la connexion des fils internes de masse.

Un dispositif semiconducteur comprend une grille de connexion, ou plus simplement "grille", comportant une plaque centrale pour recevoir une pastille ou puce formant un circuit intégré et une pluralité de pattes de connexion disposées autour de la plaque centrale. Il est également prévu des fils internes de connexion reliant pour certains d'entre eux directement des plots de la face active de la pastille à certaines des pattes de connexion, et reliant, pour certains autres, des plots de la face active de la pastille à la plaque centrale de la grille de connexion et/ou reliant la plaque centrale de la grille de connexion à certaines des pattes de connexion de cette même grille. L'ensemble de ces éléments est enrobé par moulage dans une résine pour former un boîtier.

Le moulage du boîtier d'enrobage autour de la grille de connexion et de la pastille s'effectue à une température de l'ordre de 185°C. Le boîtier est ensuite refroidi jusqu'à la température ambiante. Or, lors de ces opérations, compte tenu de la différence entre le coefficient de dilatation de la résine et le coefficient de dilatation du cuivre composant notamment la grille de connexion, il existe un risque d'apparition de défauts pouvant notamment se traduire par des craquelures, des fissures, voire des sectionnements, au niveau de la soudure des fils de masse sur la plaque centrale de la grille, et entraînant par conséquent un dysfonctionnement électrique du boîtier.

L'invention vise à apporter une solution à ce problème, et tout particulièrement dans le cas des boîtiers de petite taille, voire de très petite taille, par exemple des boîtiers carrés dont la longueur du côté est inférieure ou égale à 10 mm, voire inférieure ou égale à 7 mm .

L'invention a également pour but de minimiser à la fois le risque d'apparition de défauts au niveau de la soudure des fils de masse, et le risque de délamination, c'est-à-dire une perte d'adhésion entre la résine et la grille.

L'invention a encore pour but d'offrir ces avantages pour tout type de dispositif semiconducteur, et en particulier pour un dispositif de puissance nécessitant la présence d'un dissipateur thermique au sein du boîtier.

L'invention propose donc un dispositif semiconducteur comprenant, à l'intérieur d'un boîtier d'enrobage, une grille de connexion comportant une plaque centrale pour recevoir une pastille formant un circuit intégré et une pluralité de pattes de connexion disposées autour de la plaque centrale et débordant à l'extérieur du boîtier, et des fils internes de connexion ayant pour certains d'entre eux, généralement les fils de masse, une extrémité soudée sur la plaque centrale.

Selon une caractéristique générale de l'invention, la plaque centrale comporte plusieurs passages traversants ménagés dans une zone périphérique de la plaque centrale, chacun de ces passages traversants se situant sensiblement dans le prolongement d'une patte de connexion. Les extrémités des fils de connexion soudées sur la plaque centrale se situent au voisinage de certains au moins de ces passages traversants.

Les zones situées au voisinage de ces passages traversants présentent une certaine flexibilité visant à minimiser les effets de dilatation thermique lors de l'opération de moulage de la résine. En conséquence, le soudage des fils de masse au voisinage de ces passages traversants, c'est-à-dire sur des zones flexibles, permet de minimiser le risque d'apparition de fissures au niveau des soudures.

En outre, la présence de tels passages traversants permet à la résine d'enrobage de s'infiltrer à l'intérieur de ceux-ci, tout en enrobant les fils de connexion, ce qui augmente la solidarisation de la résine et de la grille minimisant ainsi les risques de délamination.

Par ailleurs, le fait de placer les passages traversants dans le prolongement des pattes de connexion permet de ménager les zones de soudure des fils de masse entre les prolongements des pattes de connexion, et d'offrir la possibilité à certains fils de connexion reliant directement les plots de la pastille aux pattes de connexion, de chevaucher au moins partiellement ces passages traversants. On évite ainsi dans une large mesure un chevauchement de ces fils de connexion avec les fils de masse, ce qui permet d'optimiser le schéma de connexion, de simplifier le programme de soudage des fils et de minimiser le risque de court-circuit entre deux fils, en particulier pour des dispositifs dont la plaque centrale de la grille n'est pas abaissée par rapport au plan contenant les pattes de connexion.

Il est préférable que les extrémités des fils de connexion soudées sur la plaque centrale se situent sensiblement entre les passages traversants. En effet, une plus grande flexibilité est obtenue entre les passages traversants.

Dans une variante de l'invention, les passages traversants sont limités sur tout leur pourtour. En pratique, ils peuvent être constitués de trous circulaires percés dans la plaque centrale de la grille de connexion.

Dans une telle variante notamment, lorsque la pastille est fixée sur la plaque centrale de la grille et que le dispositif comprend en outre un dissipateur thermique fixé sur la face de la plaque centrale opposée à celle recevant la pastille, il est avantageux que la zone périphérique de la plaque centrale contenant les passages traversants s'étende au-delà des limites externes du dissipateur. Ainsi, le dissipateur n'obture pas l'ouverture inférieure des trous, ce qui pourrait provoquer, lors du moulage de la résine, la création à l'intérieur de ces trous d'une poche d'air empêchant un remplissage correct de ceux-ci par la résine.

Dans une autre variante de l'invention, les passages traversants débouchent latéralement à la périphérie de la plaque centrale. En d'autres termes, ces passages traversants peuvent être constitués d'échancrures traversant la plaque centrale de part en part et ouvertes latéralement en direction des pattes de connexion. Une telle variante est particulièrement bien adaptée pour les boîtiers de très petites dimensions, par exemple des boîtiers carrés dont la longueur du côté est inférieure ou égale à 7 mm.

Dans l'une ou l'autre de ces variantes, lorsque la pastille est collée sur la plaque centrale de la grille, la zone périphérique de la plaque centrale contenant les passages traversants est avantageusement espacée du pourtour de la pastille d'au moins une distance prédéterminée, choisie de façon à ce que ladite zone périphérique soit exempte de colle. On choisira ainsi typiquement un espacement d'au moins 300 microns.

Pour réaliser des boîtiers de très petites dimensions nécessitant en outre la présence d'un dissipateur thermique, on prévoit avantageusement que la plaque centrale de la grille soit annulaire et comporte un orifice central, les passages traversants débouchant à la périphérie de la plaque centrale annulaire. Le dissipateur thermique supporte alors l'anneau périphérique de la plaque centrale et la pastille est reçue dans l'orifice central de la plaque centrale et est fixée sur le dissipateur. Les limites externes du dissipateur s'étendent alors avantageusement jusqu'au bord de l'anneau périphérique de la plaque centrale de façon à supporter les zones de l'anneau situées entre les passages traversants.

Dans une telle variante de réalisation, la pastille est directement fixée sur le dissipateur thermique de façon à assurer un meilleur échange thermique et les fils de masse sont soudés sur l'anneau périphérique de la grille de connexion fixé sur la périphérie du dissipateur. De ce fait, la présence du corps du dissipateur sous les zones de soudage des fils de masse, c'est-à-dire les zones s'étendant entre les passages traversants, permet de réaliser un appui mécanique pour ces zones favorisant l'opération de soudage des fils de masse sur ces dernières.

Les pattes de connexion de la grille comportent avantageusement des échancrures dans leur partie située à l'intérieur du boîtier. On favorise ainsi le bon accrochage de la résine sur ces pattes et on contribue ainsi à minimiser encore le risque de délamination, notamment lors du pliage des parties extérieures des pattes de connexion débordant à l'extérieur du boîtier.

De façon à minimiser le dépôt d'argent sur le cuivre de la grille de connexion, dépôt d'argent utilisé pour la soudure des fils de connexion mais accentuant les risques de délamination entre la résine et la grille de connexion, il est particulièrement avantageux que la grille ne comporte qu'un dépôt annulaire périphérique d'argent recouvrant la zone périphérique de la plaque contenant les passages traversants, ainsi qu'une partie des pattes de connexion.

La grille de connexion comporte des extensions ou "bretelles" s'étendant depuis les coins de la plaque centrale entre des groupes de pattes de connexion. On peut prévoir avantageusement que d'autres passages traversants soient également ménagés dans ces extensions ou au voisinage de ces dernières de façon à permettre le soudage éventuel de fils de connexion au voisinage de ces autres passages traversants.

L'invention a également pour objet un procédé de connexion des fils internes de masse d'un dispositif semiconducteur comprenant une grille de connexion comportant une plaque centrale pour recevoir une pastille formant un circuit intégré et une pluralité de pattes de connexion disposées autour de la plaque centrale. Selon ce procédé, on ménage des passages traversants dans une zone périphérique de la plaque centrale, chacun de ces passages se situant sensiblement dans le prolongement d'une patte de connexion de la grille, et on soude une extrémité de ces fils de masse au voisinage de certains au moins de ces passages traversants. On minimise ainsi le risque d'apparition de défauts, notamment de fissures et de craquelures, au niveau de ladite soudure des fils internes de masse sur la plaque centrale.

D'autres avantages et caractéristiques de l'invention apparaîtront à l'examen de la description détaillée de modes de réalisation et de mise en oeuvre, nullement limitatifs, et des dessins annexés, sur lesquels :
la figure 1 illustre très schématiquement une partie d'un dispositif selon l'invention,
la figure 2 illustre notamment plus complètement une grille d'un dispositif selon l'invention du type de celui de la figure 1,
les figures 3 et 4 illustrent une autre variante d'un dispositif selon l'invention, et
la figure 5 illustre partiellement une autre variante d'une grille d'un dispositif selon l'invention.

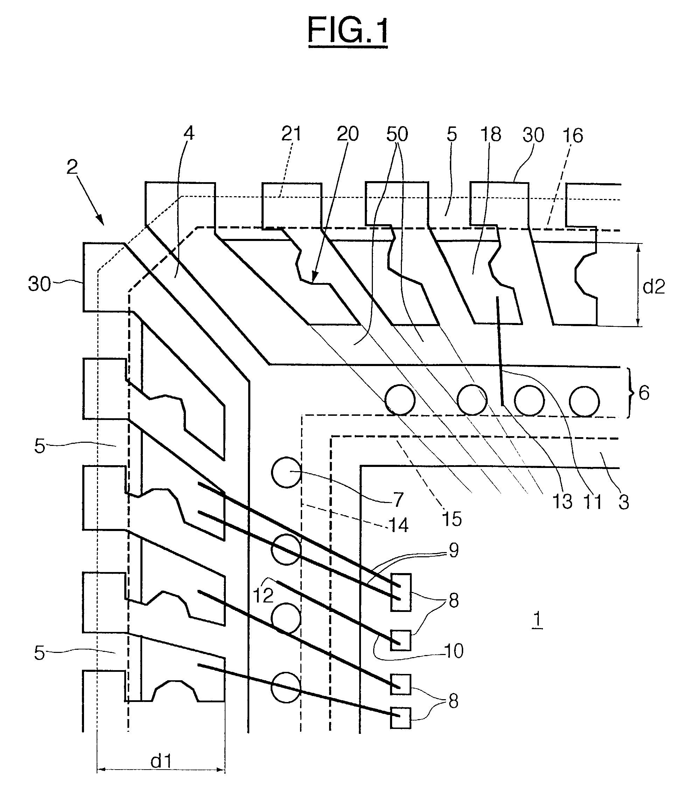

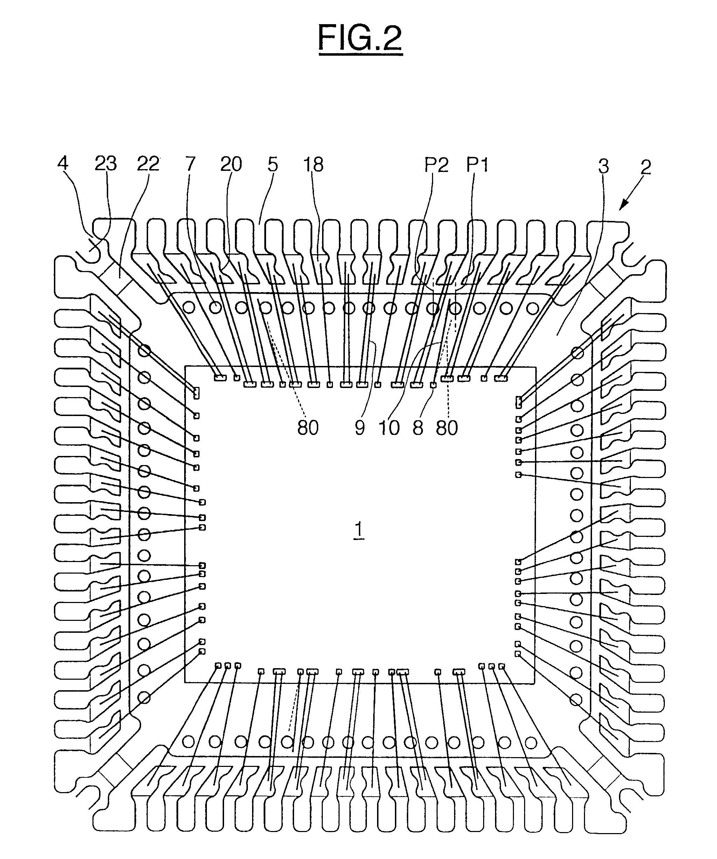

Sur les figures 1 et 2, la référence 1 désigne une pastille ou puce formant un circuit intégré comportant sur sa face active des plots de contact 8.

Un autre élément du dispositif semiconducteur consiste en une grille de connexion 2 comportant notamment une plaque centrale 3, ou plateforme, sur laquelle est fixée, par exemple par collage, la face passive de la pastille 1. Cette grille de connexion est découpée dans une plaque métallique et la plaque centrale 3 est maintenue par l'intermédiaire d'extensions ou "bretelles" s'étendant au niveau de ses coins. Entre ces bretelles 4, sont découpées des pattes de connexion 5 disposées tout autour de la plaque centrale 3.

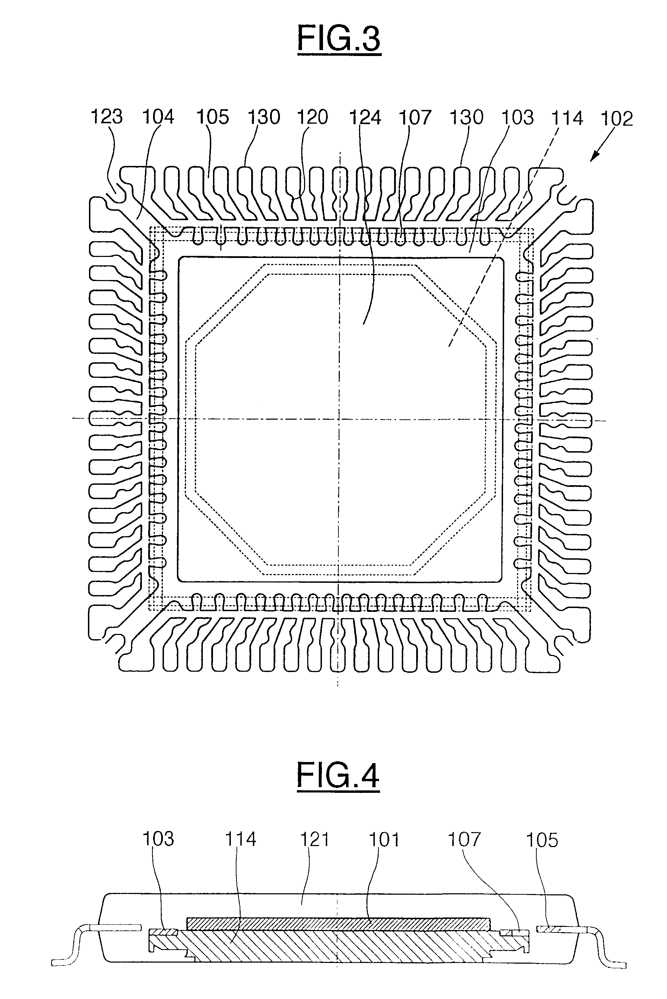

On a représenté sur ces figures, à des fins de simplification, essentiellement les parties des pattes de connexion 5 qui sont situées à l'intérieur de l'enrobage de résine, ou boîtier, 21 dont on a représenté schématiquement le pourtour en tiretés. Les pattes de connexion 5 comportent des parties débordant à l'extérieur du boîtier et qui seront ultérieurement pliées (comme illustré sur la figure 4), pour permettre la fixation du boîtier sur une carte électronique. Avant moulage de la résine 21, les pattes de connexion 5 de la grille sont mutuellement reliées par des parties de liaison 30 qui seront sectionnées après moulage et durcissement du boîtier.

Au sein d'une zone périphérique 6 de la plaque centrale 3, sont ménagés des passages traversants 7. Ces passages traversants sont ici des trous typiquement d'un diamètre de 200 microns, perforant de part en part la plaque centrale 3 de la grille. Ces trous 7 sont situés respectivement dans le prolongement des pattes de connexion 5, et plus précisément dans le prolongement 50 des parties de ces pattes de connexion situées à l'intérieur du boîtier 21.

Les trous 7 définissent à leur voisinage, et notamment entre eux, des zones présentant une certaine flexibilité et sur lesquelles sont soudés (par boule ou en biseau) les fils de masse internes du boîtier comme par exemple les fils 10 reliant des plots 8 à la plaque 3 ou bien des fils 11 reliant la plaque centrale 3 à des pattes de connexion 5. D'une façon générale, les extrémités 12, 13 de ces fils de masse sont soudées au voisinage de ces passages traversants 7, de façon à bénéficier de la flexibilité maximale de la zone considérée pour minimiser au maximum le risque d'apparition de craquelures ou de fissures lors du refroidissement de la résine de moulage.

Lorsque le percement des trous est effectué par le dessus de la plaque centrale, il en résulte au voisinage immédiat du trou un léger défaut de planéité de surface. En conséquence, on soudera de préférence l'extrémité des fils de masse à au moins 80 à 100 µ du bord des trous. Ainsi, pour des trous espacés de 160 à 200 µ environ (ce qui est généralement le cas pour les boîtiers de petite et de très petite tailles), on soudera les fils de masse de préférence à ni-distance des trous. Ce défaut de planéité ne se situe pas sur la face supérieure de la plaque lorsque le percement est effectué par le dessous. Dans ce cas, un soudage des fils de masse peut être envisagé au plus près des trous.

Par ailleurs, bien qu'il soit préférable de souder les fils de masse sensiblement entre deux passages traversants, c'est-à-dire en fait plus généralement dans une zone comprise entre deux plans diamétraux verticaux P1 et P2 (figure 2), perpendiculaires au bord adjacent de la plaque centrale 3, de ces trous, il n'est pas exclu que certains fils de masse, comme par exemple les fils référencés 80 sur la figure 2, puissent avoir leur extrémité soudée au voisinage d'un trou entre celui-ci et le bord de la pastille, ou entre celui-ci et le bord de la plaque 3.

Généralement, comme illustré en particulier sur la figure 2, on ménage un passage traversant 7 sensiblement dans le prolongement de chaque patte de connexion, même si seulement certaines seulement des zones flexibles correspondantes sont utilisées pour souder des fils de masse. Ceci permet d'utiliser une même grille pour des puces ayant un schéma de connexion différent et/ou des tailles différentes.

Le fait de placer ces passages traversants sensiblement dans le prolongement des pattes de connexion, permet d'utiliser avantageusement le volume englobant la surface du trou, exempte de matière et donc inutilisable pour souder un fil de masse, pour faire passer certains des fils de connexion internes du boîtier, reliant directement les plots 8 de la pastille à certaines des pattes de connexion, comme par exemple les fils référencés 9 sur les figures 1 et 2. On optimise ainsi le schéma de connexion pour des puces de tailles différentes et on évite notamment de faire chevaucher de tels fils de connexion 9 avec des fils de masse.

La réalisation de passages traversants 7 dans la plaque centrale de la grille de connexion permet de ménager, comme on vient de le voir, des zones flexibles pour le soudage des fils de masse, tout en permettant de conserver une distance dl pour la partie de la patte de connexion située à l'intérieur du boîtier, suffisante (typiquement de l'ordre de 0,9 mm) pour assurer une bonne tenue de ladite patte dans la résine, notamment lors du pliage. Ceci est particulièrement intéressant pour les boîtiers de petites dimensions.

Lorsque la pastille 1 est fixée sur la plateforme centrale 3 de la grille de connexion, par exemple par pressage et collage, la colle utilisée peut fluer à l'extérieur des limites de la pastille 1. La zone périphérique 6 dans laquelle sont ménagés les trous 7 doit donc se situer à une distance du pourtour de la pastille 1 telle que cette zone périphérique 6 soit exempte de colle. On choisira avantageusement un espacement d'au moins 300 microns.

Par ailleurs, lorsque, notamment pour des boîtiers de puissance, il est nécessaire de prévoir un dissipateur thermique sous la plaque centrale de la grille de connexion, il est préférable que les limites 14 du dissipateur thermique n'empiètent pas sur la zone périphérique 6 de façon à ne pas obstruer, même partiellement, les trous 7. On évite ainsi le risque d'un mauvais remplissage des trous 7 par la résine d'enrobage provoqué par la formation d'une bulle d'air dans ces trous.

Pour le soudage des fils de connexion, il est particulièrement avantageux d'effectuer un dépôt d'argent sur les zones de la grille de connexion destinées à accueillir les extrémités des fils de connexion. Cependant, compte tenu du fait que la présence d'argent contribue à augmenter le risque de délamination entre le boîtier et la grille de connexion, on limitera avantageusement le dépôt d'argent à une zone annulaire dont la limite interne 15 se situe entre la zone périphérique 6 et la pastille, et dont la limite externe 16 se situe au voisinage de la limite du boîtier 21.

Le fait de réaliser des zones flexibles dans la plaque de la grille de connexion par la perforation de passages traversants permet, en particulier pour les boîtiers de petites dimensions, de maintenir une longueur d2 de la zone argentée 18 des pattes de connexion, suffisante pour permettre le cas échéant le soudage de deux fils de connexion. Cette longueur d2 est typiquement de l'ordre de 0,5 mm.

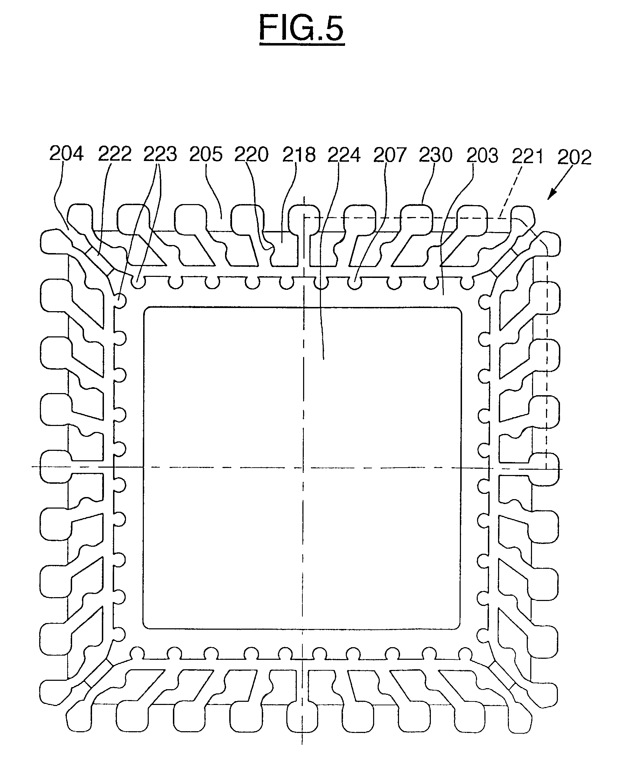

Il est également possible de prévoir de pouvoir souder des fils de masse sur des zones argentées 22 (222, figure 5) des bretelles 4 (204) de la grille de connexion. Dans ce cas, on prévoit de réaliser avantageusement également des passages traversants 23 situés directement sur la bretelle ou bien au voisinage immédiat de celle-ci (223, figure 5).

Enfin, des échancrures 20 ménagées dans les parties des pattes de connexion 5 situées à l'intérieur du boîtier permettent un enrobage solide de la résine et contribuent en combinaison avec les passages traversants 7 à minimiser les risques de délamination et à conserver un positionnement correct des pattes entre elles et vis-à-vis de la plaque centrale de la grille.

Les passages traversants ménagés à la périphérie de la plaque centrale de la grille de connexion peuvent être soit limités sur tout leur pourtour comme c'est le cas dans les variantes de réalisation des figures 1 et 2, ou bien peuvent déboucher latéralement à la périphérie de la plaque centrale, c'est-à-dire être partiellement ouverts latéralement, comme dans les variantes de réalisation illustrées sur les figures 3 à 5.

Sur ces figures, les éléments analogues ou ayant des fonctions analogues à ceux représentés sur les figures 1 et 2, ont respectivement des références augmentées de 100 et de 200 par rapport à celles qu'ils avaient sur les figures 1 et 2. A des fins de simplification, seules les différences entre ces nouvelles figures et les figures 1 et 2, seront maintenant décrites.

Le fait de prévoir des passages traversants 107 ou 207, débouchant latéralement à la périphérie de la plaque centrale de la grille de connexion 103, 203, est particulièrement avantageux pour la réalisation de boîtiers de très petite taille, par exemple des boîtiers carrés de 7 mm de côté avec une plaque centrale carrée de 5 mm de côté. En effet, une telle disposition permet de ménager des zones flexibles pour le soudage des fils de masse tout en préservant des longueurs dl et d2 suffisantes au niveau des pattes de connexion 105, 205.

Lorsqu'il est prévu un dissipateur thermique, celui-ci peut être fixé, comme dans le cas des figures 1 et 2, sous la plaque centrale de la grille de connexion. Néanmoins, afin notamment d'assurer une meilleure dissipation thermique, il est particulièrement avantageux de fixer la pastille 101 directement sur la face supérieure du dissipateur thermique 114 (figures 3 et 4). La plaque centrale 103 de la grille de connexion est alors annulaire, délimitant intérieurement un orifice central 124. Les passages traversants 107, 207 sont ménagés à la périphérie de la plaque centrale annulaire 103, 203. Cette plaque annulaire est supportée par la face supérieure du dissipateur thermique 114 et la pastille 101 est reçue dans l'orifice central 124 et fixée sur la face supérieure du dissipateur 114. Les limites externes du dissipateur 114 s'étendent alors avantageusement jusqu'au bord de la plaque annulaire 103, de façon à supporter les zones situées entre les passages traversants 107, 207. On réalise ainsi avantageusement un appui mécanique pour ces zones sur lesquelles seront éventuellement soudés les fils de masse. En effet, dans ces variantes de réalisation à dissipateur thermique directement en contact avec la pastille, les fils de masse sont soudés en présence du dissipateur alors que dans les variantes de réalisation des figures 1 et 2, c'est-à-dire avec plaque centrale pleine et dissipateur fixé sous la plaque centrale, les fils de masse sont soudés avant la pose du dissipateur et l'appui mécanique lors du soudage est obtenu directement par l'appareil de soudage.

## Revendications

1. Dispositif semiconducteur, comprenant, à l'intérieur d'un boîtier d'enrobage (21), une grille de connexion (2) comportant une plaque centrale (3) pour recevoir une pastille (1) formant un circuit intégré et une pluralité de pattes de connexion (5) disposées autour de la plaque centrale (3) et débordant à l'extérieur du boîtier (21), et des fils internes de connexion (9, 10, 11) ayant pour certains d'entre eux (9, 11) une extrémité (12, 13) soudée sur la plaque centrale, caractérisé par le fait que la plaque centrale (3) comporte plusieurs passages traversants (7) ménagés dans une zone périphérique (6) de la plaque centrale, chacun de ces passages traversants (7) se situant sensiblement dans le prolongement d'une patte de connexion (5), et par le fait que les extrémités (12, 13) des fils de connexion soudées sur la plaque centrale se situent au voisinage de certains au moins de ces passages traversants.

2. Dispositif selon la revendication 1, caractérisé par le fait que les extrémités (12, 13) de certains au moins des fils de connexion soudées sur la plaque centrale se situent sensiblement entre certains au moins des passages traversants (7).

3. Dispositif selon la revendication 1 ou 2, caractérisé par le fait que les fils internes de connexion (9, 11) ayant l'une de leurs extrémités soudées sur la plaque centrale ont l'autre extrémité soudée sur la pastille (1) ou sur une patte de connexion (5), et par le fait que les fils internes de connexion comportent d'autres fils (10) reliant directement la pastille et certaines au moins des pattes de connexion et chevauchant au moins partiellement certains au moins des passages traversants (7).

4. Dispositif selon l'une des revendications précédentes, caractérisé par le fait que les passages traversants (7) sont limités sur tout leur pourtour.

5. Dispositif selon la revendication 4, caractérisé par le fait que la pastille (1) est fixée sur la plaque centrale (3) de la grille (2), par le fait qu'il comprend en outre un dissipateur thermique (14) fixé sur la face de la plaque centrale opposée à celle recevant la pastille, et par le fait que ladite zone périphérique (6) contenant les passages traversants s'étend au delà des limites externes du dissipateur (14).

6. Dispositif selon l'une des revendications 1 à 3, caractérisé par le fait que les passages traversants (107, 207) débouchent latéralement à la périphérie de la plaque centrale.

7. Dispositif selon l'une des revendications précédentes, caractérisé par le fait que la pastille (1) est collée sur la plaque centrale (3) de la grille, et par le fait que ladite zone périphérique (6) de la plaque centrale contenant les passages traversants (7) est espacée du pourtour de la pastille d'au moins une distance prédéterminée, choisie de façon à être exempte de colle.

8. Dispositif selon la revendication 6, caractérisé par le fait que la plaque centrale (103, 203) de la grille est annulaire et comporte un orifice central (124, 224), par le fait qu'il comprend en outre un dissipateur thermique (114) supportant l'anneau de la plaque centrale, la pastille (101) étant reçue dans l'orifice central (124) de la plaque centrale et fixée sur le dissipateur (114), et par le fait que les limites externes du dissipateur (114) s'étendent jusqu'au bord de l'anneau de la plaque centrale de façon à supporter les zones de l'anneau situées entre les passages traversants.

9. Dispositif selon l'une des revendications précédentes, caractérisé par le fait que les pattes de connexion (5; 105; 205) de la grille comportent des échancrures (20; 120; 220) dans leur partie située à l'intérieur du boîtier.

10. Dispositif selon l'une des revendications précédentes, caractérisé par le fait que la grille comporte un dépôt annulaire périphérique d'argent recouvrant la zone périphérique (6) de la plaque contenant les passages traversants, ainsi qu'une partie (18; 218) des pattes de connexion.

11. Dispositif selon l'une des revendications précédentes, caractérisé par le fait que la grille comporte des extensions (4; 104; 204) s'étendant depuis les coins de la plaque centrale entre des groupes de pattes de connexion, et par le fait que d'autres passages traversants (23; 123; 223) sont également ménagés dans ces extensions ou au voisinage de celles-ci de façon à permettre le soudage éventuel de fils de connexion au voisinage de ces autres passages traversants.

12. Procédé de connexion des fils internes de masse d'un dispositif semiconducteur comprenant une grille de connexion (2) comportant une plaque centrale (3) pour recevoir une pastille (1) formant un circuit intégré et une pluralité de pattes de connexion (5) disposées autour de la plaque centrale, procédé dans lequel on ménage des passages traversants (7) dans une zone périphérique (6) de la plaque centrale, chacun de ces passages se situant sensiblement dans le prolongement d'une patte de connexion (5) de la grille, et on soude une extrémité (12, 13) de ces fils de masse au voisinage de certains au moins de ces passages traversants.

13. Procédé selon la revendication 12, caractérisé par le fait qu'on soude l'extrémité (12, 13) de certains au moins de ces fils de masse sensiblement entre certains au moins des passages traversants (7).

14. Procédé selon la revendication 12 ou 13, caractérisé par le fait qu'on limite les passages traversants (7) sur tout leur pourtour.

15. Procédé selon la revendication 12 ou 13, caractérisé par le fait qu'on fait déboucher les passages traversants (107, 207) latéralement à la périphérie de la plaque centrale.

16. Procédé selon l'une des revendications 12 à 15, caractérisé par le fait que, la grille comportant des extensions s'étendant depuis les coins de la plaque centrale entre des groupes de pattes de connexion, on ménage également d'autres passages traversants (23; 123; 223) dans ces extensions ou au voisinage de celles-ci de façon à permettre le soudage éventuel de fils de masse au voisinage de ces autres passages traversants.
